# EUROPEAN PATENT APPLICATION

(11) **EP 4 629 038 A1**
(43) Date of publication of application: **08.10.2025**
(21) Application number: 23916393.4
(22) Date of filing: 08.11.2023
(51) Int. Cl.: G06F 3/041, G06F 3/046

(54) **DISPLAY MODULE INCLUDING STRUCTURE FOR REDUCING DAMAGE AND ELECTRONIC DEVICE COMPRISING SAME**

(30) Priority: 11.01.2023 KR 20230003942; 30.01.2023 KR 20230012205
(71) Applicant: Samsung Electronics Co., Ltd., Suwon-si, Gyeonggi-do 16677 (KR)
(72) Inventor: JANG, Jisang, Suwon-si Gyeonggi-do 16677 (KR); KANG, Sunggeun, Suwon-si Gyeonggi-do 16677 (KR); KIM, Junyoung, Suwon-si Gyeonggi-do 16677 (KR); KIM, Juntae, Suwon-si Gyeonggi-do 16677 (KR); PARK, Changi, Suwon-si Gyeonggi-do 16677 (KR); AN, Minsu, Suwon-si Gyeonggi-do 16677 (KR); YU, Dakyung, Suwon-si Gyeonggi-do 16677 (KR); CHOI, Byungchul, Suwon-si Gyeonggi-do 16677 (KR)
(74) Representative: Gulde & Partner
(86) International application number: PCT/KR2023/017881
(87) International publication number: WO 2024/150910

(57) **Abstract**

An electronic device according to one embodiment comprises: a display; a first printed circuit board connected to the display and on which a display driving circuit is disposed; a second printed circuit board disposed on one side of the display and connected to the first printed circuit board; a support member disposed between the one side of the display and a first side of the second printed circuit board facing the one side of the display; and an electronic component disposed on a second side of the second printed circuit board opposite to the first side, wherein the support member includes an opening that forms an air gap disposed between a portion of the first side corresponding to the electronic component and the one side of the display.

## Description

### [Technical Field]

The present disclosure relates to a display module including a structure for reducing damage and an electronic device including the same.

### [Background Art]

An electronic device may provide visual information to a user through a display. The display may include components for implementing various functions to be provided to the user, in addition to providing visual information. For example, the display may include a sensor capable of receiving an input from the user from the outside. Various components included in the display may be accommodated in the electronic device by being disposed on a printed circuit board connected to the display.

### [Disclosure]

### [Technical Solution]

According to an embodiment, an electronic device may comprise a display including a touch sensor for detecting a user input from the outside of the electronic device. According to an embodiment, the electronic device may comprise a printed circuit board including a rigid region including a first surface facing a surface of the display and a second surface opposite to the first surface, and a flexible region connecting the rigid region and the display. According to an embodiment, the electronic device may comprise a touch sensor IC disposed on the second surface and configured to control the touch sensor. According to an embodiment, the electronic device may comprise an adhesive member contacting the surface of the display and the first surface so that the rigid region is attached on the surface of the display. According to an embodiment, the electronic device may comprise an air gap interposed between a portion of the first surface overlapping the touch sensor IC and the surface of the display and covered by the adhesive member.

According to an embodiment, a display module may comprise a display including a touch sensor for detecting a user input from the outside. According to an embodiment, the display module may comprise a printed circuit board including a rigid region including a first surface facing a surface of the display and a second surface opposite to the first surface, and a flexible region connecting the rigid region and the display. According to an embodiment, the display module may comprise a touch sensor IC disposed on the second surface and configured to control the touch sensor. According to an embodiment, the display module may comprise an adhesive member contacting the surface of the display and the first surface so that the rigid region is attached on the surface of the display. According to an embodiment, the display module may comprise an air gap interposed between a portion of the first surface overlapping the touch sensor IC and the surface of the display and covered by the adhesive member.

According to an embodiment, an electronic device may comprise a display. According to an embodiment, the electronic device may comprise a first printed circuit board on which display driving circuitry is disposed, connected to the display. According to an embodiment, the electronic device may comprise a second printed circuit board disposed on a surface of the display and connected to the first printed circuit board. According to an embodiment, the electronic device may comprise a support member disposed between the surface of the display and a first surface of the second printed circuit board, facing the surface of the display. According to an embodiment, the electronic device may comprise an electronic component disposed on a second surface of the second printed circuit board, opposite to the first surface. According to an embodiment, the support member may comprise an opening forming an air gap disposed between a portion of the first surface corresponding to the electronic component and the surface of the display.

### [Description of the Drawings]

FIG. 1 is a block diagram of an electronic device in a network environment according to various embodiments.
FIG. 2 is a block diagram of a display module according to various embodiments.
FIG. 3 is a diagram illustrating an exemplary electronic device according to an embodiment.
FIG. 4 is an exploded perspective view of an exemplary electronic device according to an embodiment.
FIG. 5A is a perspective view of an exemplary display module according to an embodiment.
FIG. 5B is an exploded perspective view of an exemplary display module according to an embodiment.
FIG. 6 is a cross-sectional view illustrating an example in which an exemplary display module according to an embodiment is coupled to an electronic device.
FIG. 7 is a top plan view of an exemplary display module according to an embodiment.

### [Mode for Invention]

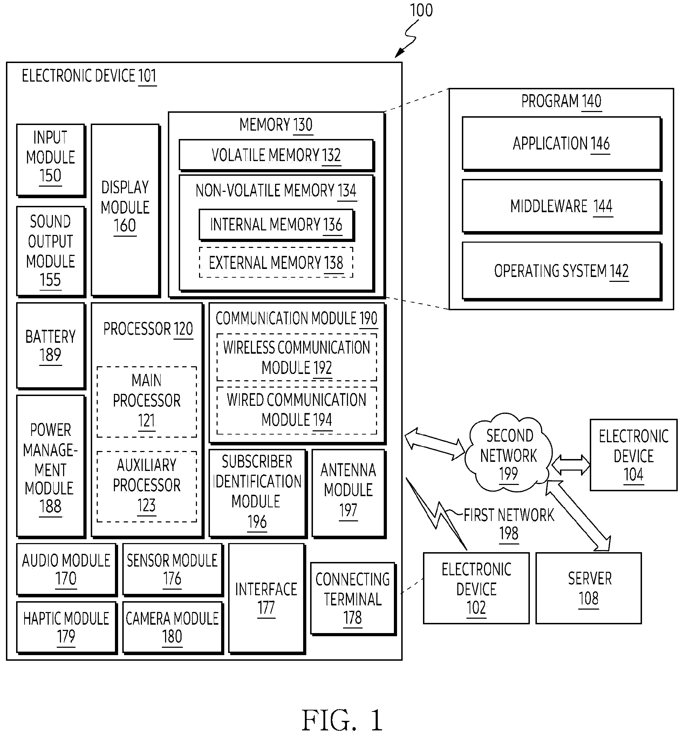

FIG. 1 is a block diagram of an electronic device in a network environment according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

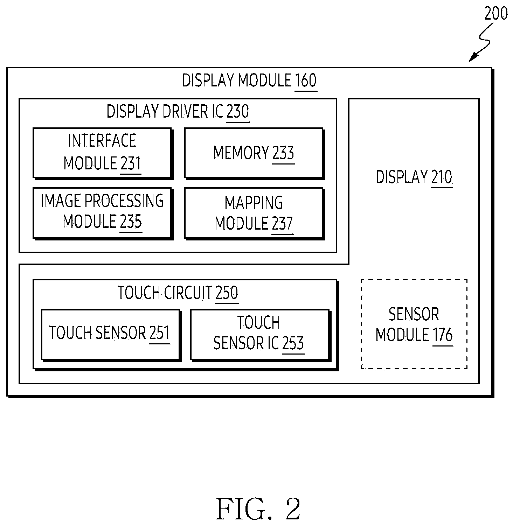

FIG. 2 is a block diagram 200 illustrating the display module 160 according to various embodiments.

Referring to FIG. 2, the display module 160 may include a display 210 and a display driver integrated circuit (DDI) 230 to control the display 210. The DDI 230 may include an interface module 231, memory 233 (e.g., buffer memory), an image processing module 235, or a mapping module 237. The DDI 230 may receive image information that contains image data or an image control signal corresponding to a command to control the image data from another component of the electronic device 101 via the interface module 231. For example, according to an embodiment, the image information may be received from the processor 120 (e.g., the main processor 121 (e.g., an application processor)) or the auxiliary processor 123 (e.g., a graphics processing unit) operated independently from the function of the main processor 121. The DDI 230 may communicate, for example, with touch circuitry 250 or the sensor module 176 via the interface module 231. The DDI 230 may also store at least part of the received image information in the memory 233, for example, on a frame by frame basis. The image processing module 235 may perform pre-processing or post-processing (e.g., adjustment of resolution, brightness, or size) with respect to at least part of the image data. According to an embodiment, the pre-processing or post-processing may be performed, for example, based at least in part on one or more characteristics of the image data or one or more characteristics of the display 210. The mapping module 237 may generate a voltage value or a current value corresponding to the image data pre-processed or post-processed by the image processing module 235. According to an embodiment, the generating of the voltage value or current value may be performed, for example, based at least in part on one or more attributes of the pixels (e.g., an array, such as an RGB stripe or a pentile structure, of the pixels, or the size of each subpixel). At least some pixels of the display 210 may be driven, for example, based at least in part on the voltage value or the current value such that visual information (e.g., a text, an image, or an icon) corresponding to the image data may be displayed via the display 210.

According to an embodiment, the display module 160 may further include the touch circuitry 250. The touch circuitry 250 may include a touch sensor 251 and a touch sensor IC 253 to control the touch sensor 251. The touch sensor IC 253 may control the touch sensor 251 to sense a touch input or a hovering input with respect to a certain position on the display 210. To achieve this, for example, the touch sensor 251 may detect (e.g., measure) a change in a signal (e.g., a voltage, a quantity of light, a resistance, or a quantity of one or more electric charges) corresponding to the certain position on the display 210. The touch circuitry 250 may provide input information (e.g., a position, an area, a pressure, or a time) indicative of the touch input or the hovering input detected via the touch sensor 251 to the processor 120. According to an embodiment, at least part (e.g., the touch sensor IC 253) of the touch circuitry 250 may be formed as part of the display 210 or the DDI 230, or as part of another component (e.g., the auxiliary processor 123) disposed outside the display module 160.

According to an embodiment, the display module 160 may further include at least one sensor (e.g., a fingerprint sensor, an iris sensor, a pressure sensor, or an illuminance sensor) of the sensor module 176 or a control circuit for the at least one sensor. In such a case, the at least one sensor or the control circuit for the at least one sensor may be embedded in one portion of a component (e.g., the display 210, the DDI 230, or the touch circuitry 250)) of the display module 160. For example, when the sensor module 176 embedded in the display module 160 includes a biometric sensor (e.g., a fingerprint sensor), the biometric sensor may obtain biometric information (e.g., a fingerprint image) corresponding to a touch input received via a portion of the display 210. As another example, when the sensor module 176 embedded in the display module 160 includes a pressure sensor, the pressure sensor may obtain pressure information corresponding to a touch input received via a partial or whole area of the display 210. According to an embodiment, the touch sensor 251 or the sensor module 176 may be disposed between pixels in a pixel layer of the display 210, or over or under the pixel layer.

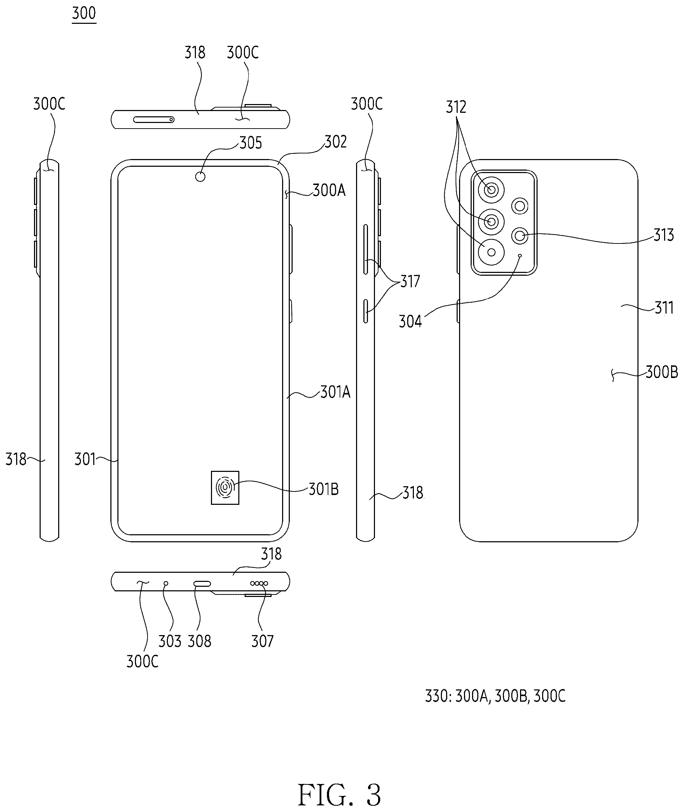

FIG. 3 is a diagram illustrating an exemplary electronic device according to an embodiment.

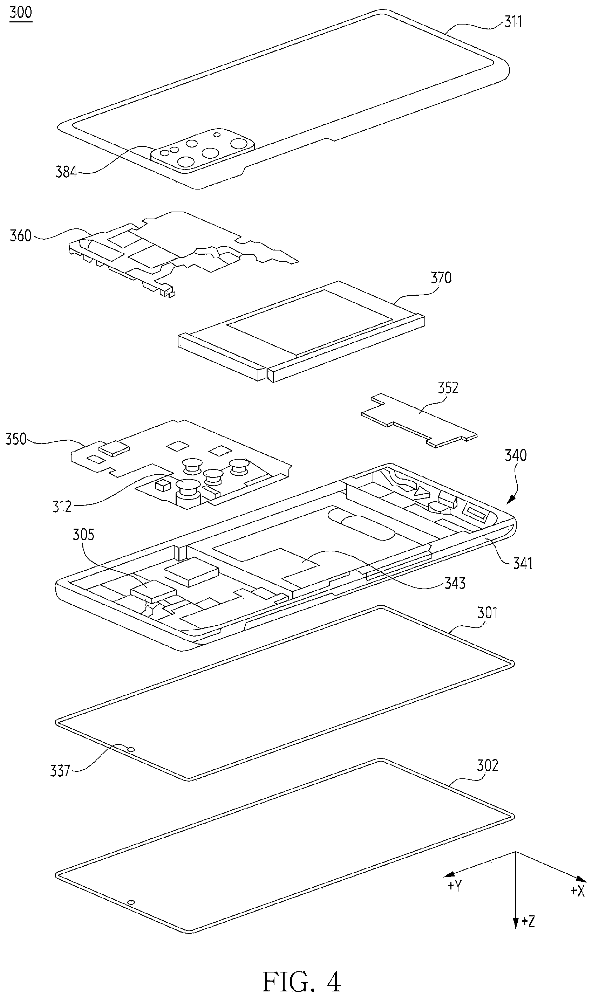

Referring to FIG. 3, according to an embodiment, an electronic device 300 (e.g., the electronic device 101 of FIG. 1) may include a housing that forms an exterior of the electronic device 300. For example, the housing may include a first surface (or a front surface) 300A, a second surface (or a rear surface) 300B, and a third surface (or a side surface) 300C surrounding a space between the first surface 300A and the second surface 300B. In an embodiment, the housing may refer to a structure (e.g., a frame structure 340 of FIG. 4) forming at least a portion of the first surface 300A, the second surface 300B, and/or the third surface 300C.

According to an embodiment, the electronic device 300 may include a substantially transparent front plate 302. In an embodiment, the front plate 302 may form at least a portion of the first surface 300A. In an embodiment, the front plate 302 may include, for example, a glass plate or a polymer plate, including various coating layers, but is not limited thereto.

According to an embodiment, the electronic device 300 may include a substantially opaque rear plate 311. In an embodiment, the rear plate 311 may form at least a portion of the second surface 300B. In an embodiment, the rear plate 311 may be formed of coated or colored glass, ceramic, a polymer, metal (e.g., aluminum, stainless steel (STS), or magnesium), or a combination of at least two of the materials.

According to an embodiment, the electronic device 300 may include a side bezel structure (or a side member) 318 (e.g., a sidewall 341 of a frame structure 340 of FIG. 4). In an embodiment, the side bezel structure 318 may form at least a portion of the third surface 300C of the electronic device 300 by being coupled with the front plate 302 and/or the rear plate 311. For example, the side bezel structure 318 may form the entire third surface 300C of the electronic device 300, and for another example, the side bezel structure 318 may form the third surface 300C of the electronic device 300 together with the front plate 302 and/or the rear plate 311.

Unlike the illustrated embodiment, in case that the third surface 300C of the electronic device 300 is partially formed by the front plate 302 and/or the rear plate 311, the front plate 302 and/or the rear plate 311 may include a region that is bent toward the rear plate 311 and/or the front plate 302 from a periphery thereof and seamlessly extends. The extending region of the front plate 302 and/or the rear plate 311 may be positioned, for example, at both ends of a long edge of the electronic device 300, but is not limited by the above-described example.

In an embodiment, the side bezel structure 318 may include metal and/or a polymer. In an embodiment, the rear plate 311 and the side bezel structure 318 may be integrally formed and may include the same material (e.g., a metallic material such as aluminum), but is not limited thereto. For example, the rear plate 311 and the side bezel structure 318 may be formed in a separate configuration and/or may include different materials.

In an embodiment, the electronic device 300 may include at least one of a display 301 (e.g., the display 210 of FIG. 2), audio modules 303, 304, and 307, a sensor module (not illustrated), camera modules 305, 312, and 313, a key input device 317, a light emitting element (not illustrated), and/or a connector hole 308. In an embodiment, the electronic device 300 may omit at least one (e.g., the key input device 317 or the light emitting element (not illustrated)) of the components, or may additionally include another component.

In an embodiment, the display 301 (e.g., the display module 160 of FIG. 1) may be visually exposed through a significant portion of the front plate 302. For example, at least a portion of the display 301 may be visible through the front plate 302 forming the first surface 300A. In an embodiment, the display 301 may be disposed on a back surface of the front plate 302.

In an embodiment, an outer periphery shape of the display 301 may be formed substantially the same as an outer periphery shape of the front plate 302 adjacent to the display 301. In an embodiment, in order to expand an area in which the display 301 is visually exposed, a distance between an outer periphery of the display 301 and an outer periphery of the front plate 302 may be formed substantially the same.

In an embodiment, the display 301 (or the first surface 300A of the electronic device 300) may include a screen display region 301A. In an embodiment, the display 301 may provide visual information to a user through the screen display region 301A. In the illustrated embodiment, when the first surface 300A is viewed from the front, the screen display region 301A is illustrated as being positioned inside the first surface 300A, spaced apart from the outer periphery of the first surface 300A, but is not limited thereto. In an embodiment, when the first surface 300A is viewed from the front, at least a portion of a periphery of the screen display region 301A may substantially coincide with a periphery of the first surface 300A (or the front plate 302).

In an embodiment, the screen display region 301A may include a sensing region 301B configured to obtain biometric information of the user. Herein, a meaning of "the screen display region 301A includes the sensing region 301B" may be understood to mean that at least a portion of the sensing region 301B may be overlapped with the screen display region 301A. For example, the sensing region 301B may mean a region capable of displaying visual information by the display 301, like another region of the screen display region 301A, and additionally obtaining the biometric information (e.g., a fingerprint) of the user. In an embodiment, the sensing region 301B may be formed in the key input device 317.

In an embodiment, the display 301 may include a region in which the first camera module 305 (e.g., the camera module 180 of FIG. 1) is positioned. In an embodiment, an opening may be formed in the region of the display 301, and the first camera module 305 (e.g., a punch hole camera) may be at least partially disposed in the opening to face the first surface 300A. For example, the screen display region 301A may surround at least a portion of a periphery of the opening. In an embodiment, the first camera module 305 (e.g., an under display camera (UDC)) may be disposed under the display 301 to overlap the region of the display 301. For example, the display 301 may provide visual information to the user through the region, and additionally, the first camera module 305 may obtain an image corresponding to a direction toward the first surface 300A through the region of the display 301.

In an embodiment, the display 301 may be coupled with or disposed adjacent to a touch sensing circuit, a pressure sensor capable of measuring an intensity (pressure) of a touch, and/or a digitizer that detects a magnetic field type stylus pen.

In an embodiment, the audio modules 303, 304, and 307 (e.g., the audio module 170 of FIG. 1) may include the microphone holes 303 and 304 and the speaker hole 307.

In an embodiment, the microphone holes 303 and 204 may include the first microphone hole 303 formed in a partial region of the third surface 300C and the second microphone hole 304 formed in a partial region of the second surface 300B. A microphone (not illustrated) for obtaining external sound may be disposed in the microphone holes 303 and 204. The microphone may include a plurality of microphones to detect a direction of sound.

In an embodiment, the second microphone hole 304 formed in the partial region of the second surface 300B may be disposed adjacent to the camera modules 305, 312, and 313. For example, the second microphone hole 304 may obtain sound according to an operation of the camera modules 305, 312, and 313. However, it is not limited thereto.

In an embodiment, the speaker hole 307 may include an external speaker hole 307 and a call receiver hole (not illustrated). The external speaker hole 307 may be formed in a portion of the third surface 300C of the electronic device 300. In an embodiment, the external speaker hole 307 may be implemented as one hole with the microphone hole 303. Although not illustrated, the call receiver hole (not illustrated) may be formed on another portion of the third surface 300C. For example, the call receiver hole may be formed on an opposite side of the external speaker hole 307 on the third surface 300C. For example, based on the illustration in FIG. 3, the external speaker hole 307 may be formed on the third surface 300C corresponding to a lower end of the electronic device 300, and the call receiver hole may be formed on the third surface 300C corresponding to an upper end of the electronic device 300. However, it is not limited thereto, and in an embodiment, the call receiver hole may be formed at a position other than the third surface 300C. For example, the call receiver hole may be formed by a separated space between the front plate 302 (or the display 301) and the side bezel structure 318.

In an embodiment, the electronic device 300 may include at least one speaker (not illustrated) configured to output sound to the outside of the housing through the external speaker hole 307 and/or the call receiver hole (not illustrated).

In an embodiment, the sensor module (not illustrated) (e.g., the sensor module 176 of FIG. 1) may generate an electrical signal or a data value corresponding to an internal operating state of the electronic device 300 or an external environmental state. For example, the sensor module may include at least one of a proximity sensor, an HRM sensor, a fingerprint sensor, a gesture sensor, a gyro sensor, a pressure sensor, a magnetic sensor, an acceleration sensor, a grip sensor, a color sensor, an infrared (IR) sensor, a biometric sensor, a temperature sensor, a humidity sensor, or a light sensor.

In an embodiment, the camera modules 305, 312, and 313 (e.g., the camera module 180 of FIG. 1) may include the first camera module 305 disposed toward the first surface 300A, the second camera module 312 disposed to face the second surface 300B, and the flash 313 of the electronic device 300.

In an embodiment, the second camera module 312 may include a plurality of cameras (e.g., a dual camera, a triple camera, or a quad camera). However, the second camera module 312 is not necessarily limited to including a plurality of cameras, and may include one camera.

In an embodiment, the first camera module 305 and the second camera module 312 may include one or more lenses, an image sensor, and/or an image signal processor.

In an embodiment, the flash 313 may include, for example, a light emitting diode or a xenon lamp. In an embodiment, two or more lenses (of an infrared camera, a wide-angle and telephoto lens) and image sensors may be disposed on a surface of the electronic device 300.

In an embodiment, the key input device 317 (e.g., the input module 150 of FIG. 1) may be disposed on the third surface 300C of the electronic device 300. In an embodiment, the electronic device 300 may not include some or all of the key input device 317, and the key input device 317 that is not included may be implemented in another form, such as a soft key, on the display 301.

In an embodiment, the connector hole 308 may be formed on the third surface 300C of the electronic device 300 to accommodate a connector of an external device. A connection terminal (e.g., the connection terminal 178 of FIG. 1) electrically connected to the connector of the external device may be disposed in the connector hole 308. According to an embodiment, the electronic device 300 may include an interface module (e.g., the interface 177 of FIG. 1) for processing an electrical signal transmitted and received through the connection terminal.

According to an embodiment, the electronic device 300 may include a light emitting element (not illustrated). For example, the light emitting element (not illustrated) may be disposed on the first surface 300A of the housing. The light emitting element (not illustrated) may provide state information of the electronic device 300 in an optical form. In an embodiment, the light emitting element (not illustrated) may provide a light source linked with an operation of the first camera module 305. For example, the light emitting element (not illustrated) may include an LED, an IR LED, and/or a xenon lamp.

FIG. 4 is an exploded perspective view of an electronic device according to an embodiment.

Hereinafter, a redundant description of a configuration having the same reference numeral as the above-described configuration will be omitted.

Referring to FIG. 4, according to an embodiment, an electronic device 300 may include a frame structure 340, a first printed circuit board 350, a second printed circuit board 352, a cover plate 360, and a battery 370.

In an embodiment, the frame structure 340 may include a sidewall 341 forming an exterior (e.g., the third surface 300C of FIG. 3) of the electronic device 300 and a support portion 343 extending inward from the sidewall 341. In an embodiment, the frame structure 340 may be disposed between a display 301 and a rear plate 311. In an embodiment, the sidewall 341 of the frame structure 340 may surround a space between the rear plate 311 and a front plate 302 (and/or the display 301) and the support portion 343 of the frame structure 340 may extend from the sidewall 341 in the space.

In an embodiment, the frame structure 340 may support or accommodate other components included in the electronic device 300. For example, the display 301 may be disposed on a surface of the frame structure 340 facing a direction (e.g., a +z direction), and the display 301 may be supported by the support portion 343 of the frame structure 340. For example, the first printed circuit board 350, the second printed circuit board 352, the battery 370, and a second camera module 312 may be disposed on another surface of the frame structure 340 facing a direction (e.g., a -z direction) opposite to the direction. The first printed circuit board 350, the second printed circuit board 352, the battery 370, and the second camera module 312 may be respectively seated in recesses defined by the sidewall 341 and/or the support portion 343 of the frame structure 340.

In an embodiment, the first printed circuit board 350, the second printed circuit board 352, and/or the battery 370 may be disposed in the frame structure 340. For example, the first printed circuit board 350 and the second printed circuit board 352 may be fixedly disposed in the frame structure 340 through a coupling member such as a screw. For example, the battery 370 may be fixedly disposed in the frame structure 340 through an adhesive member (e.g., a double-sided tape). However, it is not limited by the above-described example.

In an embodiment, the cover plate 360 may be disposed between the first printed circuit board 350 and the rear plate 311. In an embodiment, the cover plate 360 may be disposed on the first printed circuit board 350. For example, the cover plate 360 may be disposed on a surface of the first printed circuit board 350 facing the -z direction.

In an embodiment, the cover plate 360 may at least partially overlap the first printed circuit board 350 with respect to a z-axis. In an embodiment, the cover plate 360 may cover at least a portion of a region of the first printed circuit board 350. Accordingly, the cover plate 360 may protect the first printed circuit board 350 from a physical impact or prevent a connector (e.g., a connector 334 of FIG. 4) coupled to the first printed circuit board 350 from being separated.

In an embodiment, the cover plate 360 may be fixedly disposed on the first printed circuit board 350 through a coupling member (e.g., a screw), or may be coupled to the frame structure 340 through the coupling member.

In an embodiment, the display 301 may be disposed between the frame structure 340 and the front plate 302. For example, the front plate 302 may be disposed on a side (e.g., the +z direction) of the display 301, and the frame structure 340 may be disposed on another side (e.g., the -z direction).

In an embodiment, the front plate 302 may be coupled to the display 301. For example, the front plate 302 and the display 301 may be adhered to each other through an optical adhesive member (e.g., an optically clear adhesive (OCA) or an optically clear resin (OCR)) interposed therebetween.

In an embodiment, the front plate 302 may be coupled to the frame structure 340. For example, the front plate 302 may include an outer periphery portion extending outside the display 301 when viewed in the z-axis direction, and may be adhered to the frame structure 340 through an adhesive member (e.g., a double-sided tape) disposed between the outer periphery portion of the front plate 302 and the frame structure 340 (e.g., the sidewall 341). However, it is not limited by the above-described example.

In an embodiment, a processor (e.g., the processor 120 of FIG. 1), memory (e.g., the memory 130 of FIG. 1), and/or an interface (e.g., the interface 177 of FIG. 1) may be disposed on the first printed circuit board 350 and/or the second printed circuit board 352. The processor may include, for example, one or more of a central processing unit, an application processor, a graphic processing unit, an image signal processor, a sensor hub processor, or a communication processor. The memory may include, for example, volatile memory or non-volatile memory. The interface may include, for example, a high definition multimedia interface (HDMI), a universal serial bus (USB) interface, an SD card interface, and/or an audio interface. The interface may electrically or physically connect the electronic device 300 to an external electronic device, and may include a USB connector, an SD card/MMC connector, or an audio connector. In an embodiment, the first printed circuit board 350 and the second printed circuit board 352 may be operably or electrically connected to each other through a connection member (e.g., a flexible printed circuit board).

In an embodiment, the battery 370 (e.g., the battery 189 of FIG. 1) may supply power to at least one component of the electronic device 300. For example, the battery 370 may include a rechargeable secondary battery or a fuel cell. At least a portion of the battery 370 may be disposed on substantially the same plane as the first printed circuit board 350 and/or the second printed circuit board 352.

According to an embodiment, the electronic device 300 may include an antenna module (not illustrated) (e.g., the antenna module 197 of FIG. 1). In an embodiment, the antenna module may be disposed between the rear plate 311 and the battery 370. The antenna module may include, for example, a near field communication (NFC) antenna, a wireless charging antenna, and/or a magnetic secure transmission (MST) antenna. The antenna module may, for example, perform short-range communication with an external device or wirelessly transmit and receive power to and from an external device.

In an embodiment, a first camera module 305 (e.g., a front camera) may be disposed in at least a portion (e.g., the support portion 343) of the frame structure 340 so that a lens may receive external light through a portion (e.g., a camera region 337) of the front plate 302 (e.g., the front surface 300A of FIG. 3).

In an embodiment, the second camera module 312 (e.g., a rear camera) may be disposed between the frame structure 340 and the rear plate 311. In an embodiment, the second camera module 312 may be electrically connected to the first printed circuit board 350 through a connection member (e.g., a connector). In an embodiment, the second camera module 312 may be disposed so that the lens may receive external light through the camera region 384 of the rear plate 311 of the electronic device 300.

In an embodiment, the camera region 384 may be formed on a surface (e.g., the rear surface 300B of FIG. 3) of the rear plate 311. In an embodiment, the camera region 384 may be formed to be at least partially transparent so that external light may be incident to the lens of the second camera module 312. In an embodiment, at least a portion of the camera region 384 may protrude from the surface of the rear plate 311 by a predetermined height. However, it is not limited thereto, and in an embodiment, the camera region 384 may form substantially the same plane as the surface of the rear plate 311.

In an embodiment, a housing of the electronic device 300 may mean a configuration or a structure forming at least a portion of an exterior of the electronic device 300. In this regard, at least a portion of the front plate 302, the frame structure 340, and/or the rear plate 311 forming the exterior of the electronic device 300 may be referred to as the housing of the electronic device 300.

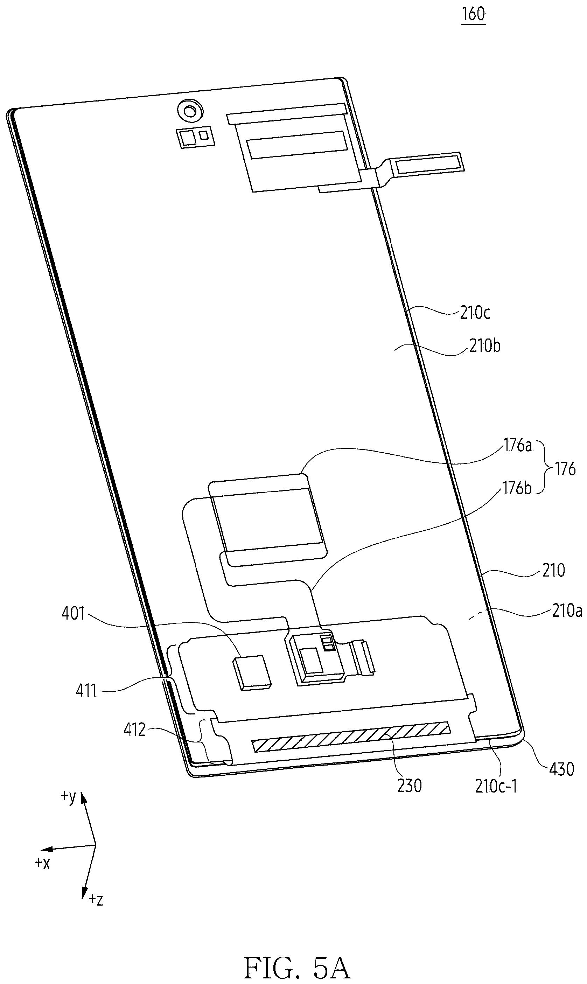

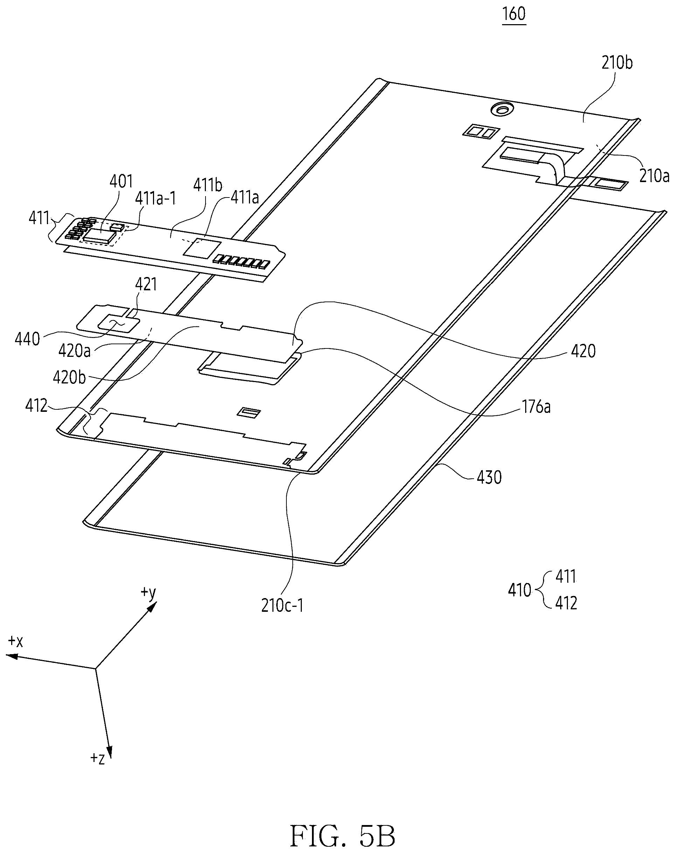

FIG. 5A is a perspective view of an exemplary display module according to an embodiment, and FIG. 5B is an exploded perspective view of an exemplary display module according to an embodiment.

Referring to FIGS. 5A and 5B, according to an embodiment, a display module 160 may include a display 210, display driving circuitry (DDI) 230, a touch sensor (not illustrated) (e.g., the touch sensor 251 of FIG. 2), an electronic component 401, a printed circuit board 410, an adhesive member 420, a window 430, and/or an air gap 440. Since the display module 160 of FIGS. 5A and 5B may be substantially the same as the display module 160 of FIG. 2, a redundant description thereof will be omitted.

According to an embodiment, the display 210 may be configured to emit light for providing visual information toward the outside of the display module 160. The display 210 may include a plurality of layers stacked on each other in the display 210. For example, the plurality of layers of the display 210 may include a pixel layer that emits light through a surface 210a of the display 210 in the display 210. For example, a pixel layer in the display 210 may emit light to provide visual content to a user through a plurality of pixels included in the pixel layer. For example, the plurality layers of the display 210 may include a touch sensor 251. The touch sensor 251 may detect a user input from the outside of the display module 160. For example, the touch sensor 251 may detect the user input touching the display 210. For example, the touch sensor 251 may include conductive patterns (not illustrated) for receiving an input from the outside, and an insulating layer disposed between the conductive patterns. When capacitance between the conductive patterns is changed by the input of the user through the display 210, the touch sensor 251 may obtain an electric signal corresponding to the input of the user. A processor 120 may identify the user input on the display 210 based on receiving an electric signal from the touch sensor 251. The touch sensor 251 may be disposed above or below the pixel layer of the display 210.

According to an embodiment, another surface 210b of the display 210 may be opposite to the surface 210a of the display 210. For example, a direction (e.g., a -z direction) in which the other surface 210b of the display 210 faces may be opposite to a direction (e.g., a +z direction) in which the surface 210a of the display 210 faces. For example, the other surface 210b of the display 210 may be substantially parallel to the surface 210a of display 210. Some of the components included in the display module 160 may be positioned on the other surface 210b of the display 210. For example, some of the components in the display module 160 included in the display module 160 may be supported by the other surface 210b of the display 210. The other surface 210b of the display 210 may be spaced apart from the surface 210a of the display 210. For example, the other surface 210b of the display 210 may be spaced apart from the surface 210a of the display 210 along the direction (e.g., the -z direction) in which the other surface 210b of the display 210 faces. According to an embodiment, the other surface 210b of the display 210 may be defined by at least one of a copper sheet or an insulating sheet included in the display 210. The other surface 210b of the display 210 may be formed of at least one of the copper sheet or the insulating sheet included in the display 210. At least one of the copper sheet or the insulating sheet included in the display 210 may be exposed to the outside of the display 210 to protect components in the display 210. Side surfaces 210c of the display 210 may connect the surface 210a of the display 210 and the other surface 210b of the display 210. For example, the side surfaces 210c of the display 210 may connect a periphery of the surface 210a of the display 210 and a periphery of the other surface 210b of the display 210. The side surfaces 210c of the display 210 may surround the surface 210a of the display 210 and the other surface 210b of the display 210. For example, the side surfaces 210c of the display 210 may be substantially perpendicular to the surface 210a of the display 210 and the other surface 210b of the display 210. According to an embodiment, the side surfaces 210c of the display 210 may include a step defined by a plurality of layers in the display 210. The step formed on the side surfaces 210c of the display 210 may be formed by a difference in a length of the plurality of layers in the display 210.

According to an embodiment, display driving circuitry 230 may control the display 210. For example, the display driving circuitry 230 may be configured to provide visual information through the display 210 based on receiving an image control signal and image data from a processor (e.g., the processor 120 of FIG. 1). According to an embodiment, the display driving circuitry 230 may be disposed outside the display 210. For example, the display driving circuitry 230 may be positioned on the other surface 210b of the display 210. For example, the display driving circuitry 230 may be spaced apart from the other surface 210b of the display 210 in a direction (e.g., the -z direction) in which the other surface 210b of the display faces. For example, the display driving circuitry 230 may be disposed on a portion of the printed circuit board 410.

According to an embodiment, the electronic component 401 may be configured to provide at least one function to a user. For example, the electronic component 401 may include a touch sensor IC (e.g., the touch sensor IC 253 of FIG. 2) that controls the touch sensor 251. In case that the electronic component 401 includes the touch sensor IC 253, the electronic component 401 may transmit an electric signal from the touch sensor 251 obtained by a user input through the display 210 to the processor 120. However, it is not limited thereto. As an example without limitation, the electronic component 401 may include at least one of a fingerprint sensor IC, a pressure sensor IC, a proximity sensor IC, or a light sensor IC. According to an embodiment, the electronic component 401 may be positioned on the other surface 210b of the display 210. For example, the electronic component 401 may be spaced apart from the other surface 210b of the display 210 in a direction (e.g., the -z direction) in which the other surface 210b of the display faces. For example, the electronic component 401 may be disposed on a portion of the printed circuit board 410.

According to an embodiment, the printed circuit board 410 may form an electrical connection between electronic components of the display module 160. The printed circuit board 410 may form an electrical connection between an electronic component of the display module 160 and an electronic component (e.g., the processor 120 of FIG. 1) outside the display module 160. The printed circuit board 410 may support the electronic components of the display module 160. According to an embodiment, the printed circuit board 410 may include a rigid region 411 and a flexible region 412.

According to an embodiment, the rigid region 411 may support the electronic components of the display module 160. For example, the rigid region 411 may support the electronic component 401. For example, the electronic component 401 may be disposed on the rigid region 411. The rigid region 411 may have relatively stiffness compared to the flexible region 412. For example, the rigid region 411 may not be deformed by an external force having a magnitude in a designated range. The rigid region 411 may include a first surface 411a and a second surface 411b. The first surface 411a may face the other surface 210b of the display 210. For example, a direction (e.g., the +z direction) in which the first surface 411a faces may be opposite to a direction (e.g., -z direction) in which the other surface 210b of the display 210 faces. For example, the first surface 411a may be spaced apart from the other surface 210b of the display 210 along the direction (e.g., the -z direction) in which the other surface 210b of the display 210 faces. The second surface 411b may be opposite to the first surface 411a. For example, a direction (e.g., the -z direction) in which the second surface 411b faces may be opposite to a direction (e.g., the +z direction) in which the first surface 411a faces. For example, the second surface 411b may be substantially parallel to the first surface 411a. For example, the second surface 411b may be spaced apart from the first surface 411a. The second surface 411b may support electronic components disposed on the rigid region 411. For example, the electronic component 401 may be disposed on the second surface 411b of the rigid region 411. According to an embodiment, the rigid region 411 may include a supporting plate (not illustrated) having stiffness, included in a portion of the rigid region 411 in which the electronic component 401 is disposed. For example, the supporting plate may include at least one of a metal material, a plastic, or a carbon. For example, as the rigid region 411 includes the supporting plate having stiffness, the rigid region 411 may have relatively stiffness compared to the flexible region 412.

According to an embodiment, the flexible region 412 may have flexibility. For example, the flexible region 412 may be deformed by an external force having a magnitude in a designated range. The flexible region 412 may connect the rigid region 411 and the display 210. For example, the flexible region 412 may electrically connect the rigid region 411 and the display 210. For example, an end of the flexible region 412 may be connected to the rigid region 411, and another end of the flexible region 412 may be connected to the display 210. The other end of the flexible region 412 may be connected to a first side surface 210c-1 among the side surfaces 210c of the display 210. The first side surface 210c-1 may be directed in a first direction (e.g., a -y direction). For example, the flexible region 412 may extend from the rigid region 411 to the first side surface 210c-1 of the display 210. According to an embodiment, the flexible region 412 may be bent. For example, a portion of the flexible region 412 disposed on the other surface 210b of the display 210 may be substantially parallel to the other surface 210b of the display 210. For example, another portion of the flexible region 412 may be bent with respect to the other surface 210b of the display 210. For example, the other portion of the flexible region 412 may be bent with respect to the first side surface 210c-1 of the display 210. For example, the flexible region 412 may have a curvature and may be bent, but is not limited thereto. According to an embodiment, the flexible region 412 may be referred to as a flexible printed circuit board (FPCB). For example, since the printed circuit board 410 includes the rigid region 411 and the flexible region 412, it may be referred to as a rigid flexible printed circuit board (RFPCB). According to an embodiment, the flexible region 412 may support the display driving circuitry 230. The display driving circuitry 230 may be disposed on the flexible region 412. For example, the display driving circuitry 230 may be disposed on a surface of the flexible region 412 facing the other surface 210b of the display 210. For example, the display driving circuitry 230 may be disposed on another surface of the flexible region 412 opposite to the surface of the flexible region 412 facing the other surface 210b of the display 210.

According to an embodiment, the rigid region 411 may be integrally formed in the flexible region 412. However, it is not limited thereto. According to an embodiment, the rigid region 411 and the flexible region 412 may be referred to as a separately formed printed circuit board. For example, in case that the rigid region 411 and the flexible region 412 are formed separately, the rigid region 411 may be referred to as a printed circuit board that is distinct from the flexible region 412, and the flexible region 412 may be referred to as another printed circuit board that is distinct from the rigid region 411. For example, in case that the rigid region 411 and the flexible region 412 are formed separately, the rigid region 411 and the flexible region 412 may be connected to each other through solder or a connector.

According to an embodiment, the adhesive member 420 may attach the rigid region 411 to the display 210. For example, the adhesive member 420 may be adhered to at least one of the surface 210b and the first surface 411a of the display 210. For example, the adhesive member 420 may attach the rigid region 411 to the other surface 210b of the display 210. The adhesive member 420 may include an adhesive material for attaching the rigid region 411 to the display 210. For example, the adhesive member 420 may include the adhesive material disposed on a surface 420a of the adhesive member 420 facing the other surface 210b of the display 210. For example, the adhesive member 420 may include the adhesive material disposed on another surface 420b of the adhesive member 420 facing the first surface 411a of the rigid region 411. The adhesive member 420 may be referred to as a double sided tape when including the adhesive material disposed on the surface 420a of the adhesive member 420 and the other surface 420b of the adhesive member 420. According to an embodiment, the adhesive member 420 may be disposed between the rigid region 411 and the display 210. The adhesive member 420 may be interposed between the first surface 411a and the other surface 210b of the display 210. The adhesive member 420 may be in contact with the first surface 411a and the other surface 210b of the display 210. According to an embodiment, the adhesive member 420 may be parallel to the first surface 411a and the other surface 210b of the display 210. The adhesive member 420 may have a thickness corresponding to a distance between the other surface 210b of the display and the first surface 411a. A thickness of a component may mean a distance in a direction (e.g., the +z direction or the -z direction) parallel to the direction (e.g., the -z direction) in which the other surface 210b of the display 210 faces. According to an embodiment, an area of the adhesive member 420 may be substantially the same as an area of at least a portion of the rigid region 411. For example, a periphery of the adhesive member 420 may overlap a periphery of the rigid region 411. For example, when the rigid region 411 is attached to the display 210 by the adhesive member 420, the flexible region 412 may be bent with respect to the first side surface 210c-1 of the display 210. As the flexible region 412 is bent with respect to the first side surface 210c-1 of the display 210, the adhesive member 420 may be attached on the other surface 210b of the display 210 along a second direction (e.g., a +y direction) opposite to the first direction (e.g., a -y direction). The second direction may be a direction in which the rigid region 411 is attached to the other surface 210b of the display 210 by the adhesive member 420. According to an embodiment, since the adhesive member 420 performs a function of supporting the rigid region 411, it may be referred to as a support member. According to an embodiment, a thickness of the adhesive member 420 may be 0.01 mm to 0.1 mm. For example, a thickness of the adhesive member 420 may be 0.08 mm, but is not limited thereto. According to an embodiment, the adhesive member 420 may be a tape having electrical insulation property, but is not limited thereto. For example, the adhesive member 420 may be formed of a tape including a conductive material.

According to an embodiment, the display module 160 may further include a sensor module 176. The sensor module 176 may include a sensor 176a and another printed circuit board 176b. The sensor 176a may obtain information from the outside of the display module 160. According to an embodiment, the sensor 176a may obtain information for identifying the user of an electronic device (e.g., the electronic device 101 of FIG. 1 and the electronic device 300 of FIG. 3). For example, the sensor 176a may obtain biometric information for identifying a fingerprint of the user of an electronic device in contact with the surface 210a of the display 210. For example, the sensor 176a may include an ultrasonic sensor for identifying the fingerprint of the user, but is not limited thereto. For example, the sensor 176a may include a capacitive sensor and/or an optical sensor for identifying the fingerprint of the user. According to an embodiment, the sensor 176a may be disposed on the other surface 210b of the display 210. For example, the sensor 176a may be visible from the outside of the display 210 when the display 210 is viewed in the direction (e.g., the -z direction) that the other surface 210b of the display 210 faces. According to an embodiment, the other printed circuit board 176b may connect the sensor 176a and the rigid region 411. For example, an end of the other printed circuit board 176b may be connected to the sensor 176a. For example, another end of the other printed circuit board 176b may be disposed on the second surface 411b of the rigid region 411. For example, the other end of the other printed circuit board 176b may be connected to the rigid region 411 through a connector disposed on the second surface 411b of the rigid region 411.

According to an embodiment, the window 430 (e.g., the front plate 302 of FIG. 4) may protect the display 210. The window 430 may be disposed on the surface 210a of the display 210. For example, the display module 160 may include an adhesive layer (not illustrated) disposed between the surface 210a of the display 210 and the window 430. The adhesive layer may include an adhesive material for attaching the window 430 to the surface 210a of the display 210. The window 430 may be formed of a substantially transparent material. As the window 430 is formed of a substantially transparent material, light emitted through the surface 210a of the display 210 may be transmitted to the outside of the display 210 by passing through the window 430.

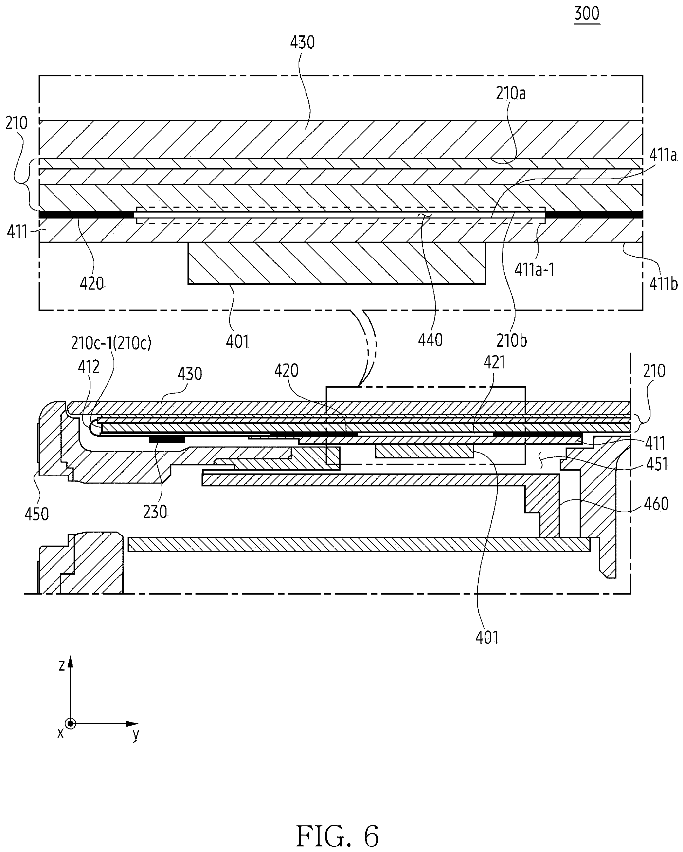

According to an embodiment, the air gap 440 may include an empty space disposed between the rigid region 411 and the display 210. According to an embodiment, the adhesive member 420 may include an opening 421 forming the air gap 440 disposed between a portion 411a-1 of the first surface 411a and the other surface 210b of the display 210. For example, the opening 421 may be defined by removing a portion of the adhesive member 420 overlapping the portion 411a-1 of the first surface 411a. For example, the air gap 440 may be defined by removing a portion of the adhesive member 420 overlapping the portion 411a-1 of the first surface 411a. The portion 411a-1 of the first surface 411a may correspond to the electronic component 401. The portion 411a-1 of the first surface 411a may overlap the electronic component 401. For example, the portion 411a-1 of the first surface 411a may overlap the electronic component 401 when the rigid region 411 is viewed along the direction (e.g., the +z direction) that the first surface 411a faces. According to an embodiment, a magnitude of the air gap 440 may correspond to a magnitude of the electronic component 401. For example, the magnitude of the air gap 440 may correspond to the magnitude of the electronic component 401 when the rigid region 411 is viewed along the direction (e.g., the +z direction) in which the first surface 411a faces. For example, the magnitude of the air gap 440 may be greater than or equal to a magnitude of the electronic component 401 when the rigid region 411 is viewed along the direction (e.g., the +z direction) in which the first surface 411a faces, but is not limited thereto. For example, the magnitude of the air gap 440 may be smaller than the magnitude of the electronic component 401 when the rigid region 411 is viewed along the direction (e.g., the +z direction) in which the first surface 411a faces. According to an embodiment, the adhesive member 420 may be disposed around the air gap 440. The air gap 440 may be covered by the adhesive member 420. The air gap 440 may be surrounded by the adhesive member 420. According to an embodiment, the air gap 440 may protect the electronic component 401. For example, the air gap 440 may decrease damage to the electronic component 401 due to an impact transmitted from the surface 210a of the display 210. The electronic component 401 being protected by the air gap 440 may be described with reference to FIG. 6.

FIG. 6 is a cross-sectional view illustrating an example in which an exemplary display module according to an embodiment is coupled to an electronic device.

Referring to FIG. 6, according to an embodiment, an electronic device 300 may include a support member 450 (e.g., the frame structure 340 of FIG. 4) and/or a support structure 460. The support member 450 may support a display module 160. For example, the support member 450 may support another surface 210b of a display 210. The display 210 may be disposed on the support member 450. A surface 210a of the display 210 may be exposed to the outside of the support member 450. The other surface 210b of the display 210 and side surfaces 210c of the display 210 may be covered by the support member 450. According to an embodiment, the support member 450 may form at least a portion of the housing of FIG. 3. For example, the support member 450 may form a portion of the housing of FIG. 3. In case that the support member 450 forms a portion of the housing of FIG. 3, the support member 450 may define a portion of an outer surface of the electronic device 300. The support member 450 may be referred to as a bracket. According to an embodiment, the support member 450 may include a through hole 451.

According to an embodiment, the through hole 451 may penetrate the support member 450. The through hole 451 may be disposed under a rigid region 411. A position of the through hole 451 may correspond to a position of an electronic component 401. For example, an area of the through hole 451 may be larger than an area of the electronic component 401.

According to an embodiment, a flexible region 412 of a printed circuit board 410 may be spaced apart from the support member 450. For example, a portion of the flexible region 412 in which display driving circuitry 230 is disposed may be spaced apart from the support member 450 along a direction in which the surface 210a of the display 210 faces. For example, the support member 450 may be spaced apart from another portion of the flexible region 412 connected to a first side surface 210c-1 along a first direction (e.g., a -y direction) in which the first side surface 210c-1 of the side surfaces 210c of the display 210 faces.

According to an embodiment, the display driving circuitry 230 disposed on the flexible region 412 of the printed circuit board 410 may be disposed on the support member 450. For example, the display driving circuitry 230 may be spaced apart from the support member 450 along a direction (e.g., a +z direction) in which the surface 210a of the display 210 faces.

According to an embodiment, the support structure 460 may be disposed in the support member 450. The support structure 460 may be spaced apart from the display 210. For example, the support structure 460 may be spaced apart from the display 210 along a direction (e.g., a -z direction) in which the other surface 210b of the display 210 faces. The support structure 460 may support a component disposed in the electronic device 300. For example, the support structure 460 may support an interface bracket (not illustrated) coupled to an interface chip (not illustrated). The interface bracket may be inserted into the support structure 460. The interface chip may be configured to store data on an identifier for identifying a subscriber of a network (e.g., the second network 199 of FIG. 1) for long-distance wireless communication of the electronic device 300. For example, the interface chip may be configured to store data for implementing short-range wireless communication (e.g., near field communication (NFC)) of the electronic device 300. For example, the interface chip may include data required for an operation of software (e.g., an application) of the electronic device 300. The data required for the operation of the software may include at least one of information on identification information (e.g., a phone number) of another electronic device capable of communicating with the electronic device 300 and information for a financial payment of the user, but is not limited thereto. According to an embodiment, the interface chip may be referred to as a subscriber identification module (SIM) card, a universal subscriber identity module (USIM) card, and/or a secure digital card (SD card), but is not limited thereto. In case that the support structure 460 supports the interface bracket accommodating the SIM card, the support structure 460 may be referred to as a SIM socket.

According to an embodiment, an air gap 440 may be interposed between a portion 411a-1 of a first surface 411a of the rigid region 411 and the other surface 210b of the display 210. The air gap 440 may form an empty space between the portion 411a-1 of the first surface 411a and the other surface 210b of the display 210. For example, a distance between the portion 411a-1 of the first surface 411a and the other surface 210b of the display 210 may be substantially the same as a thickness of the air gap 440. According to an embodiment, the air gap 440 may buffer an impact transmitted from the outside of the electronic device 300 to the electronic component 401. For example, the impact transmitted from the outside of the electronic device 300 may be transmitted to the electronic component 401 by passing through the other surface 210b of the display 210 and the adhesive member 420. In case that the air gap 440 is omitted, since the electronic component 401 is disposed on the rigid region 411 having relatively stiffness, the electronic component 401 may be more vulnerable to the impact than the display driving circuitry 230 disposed on the flexible region 412 having relatively flexibility. According to an embodiment, the electronic device 300 may provide a structure for decreasing the impact transmitted to the electronic component 401 by the air gap 440 disposed between the first surface 411a of the rigid region 411 and the other surface 210c of the display 210. As the impact transmitted to the electronic component 401 is decreased, damage to the electronic component 401 may be decreased.

According to an embodiment, the electronic component 401 may overlap at least a portion of the support structure 460. The electronic component 401 may be disposed above the support structure 460. For example, the electronic component 401 may be spaced apart from the support structure 460 along the direction (e.g., the +z direction) in which the surface 210a of the display 210 faces. For example, in case that the impact is transmitted to the display 210 from the outside of the electronic device 300, the display 210 may be deformed to approach the support structure 460. As the display 210 is deformed to approach the support structure 460, the electronic component 401 disposed on a second surface 411b of the rigid region 411 may temporarily contact the support structure 460. In case that the air gap 440 is omitted, damage to the electronic component 401 may occur due to an impact generated by the temporary contact between the electronic component 401 and the support structure 460. According to an embodiment, the electronic device 300 may provide a structure for decreasing damage to the electronic component 401 due to contact with the support structure 460 by the air gap 440 disposed between the portion 411a of the first surface 411a and the electronic component 401. For example, as the impact generated when the electronic component 401 contacts the support structure 460 is buffered by the air gap 440, an amount of the impact transmitted to the electronic component 401 may be decreased. As the amount of the impact transmitted to the electronic component 401 is decreased, damage to the electronic component 401 may be decreased.

As described above, according to an embodiment, the display module 160 and the electronic device 300 may provide a structure for decreasing damage to the electronic component 401 disposed on the rigid region 411 by the air gap 440 disposed between the rigid region 411 and the display 210.

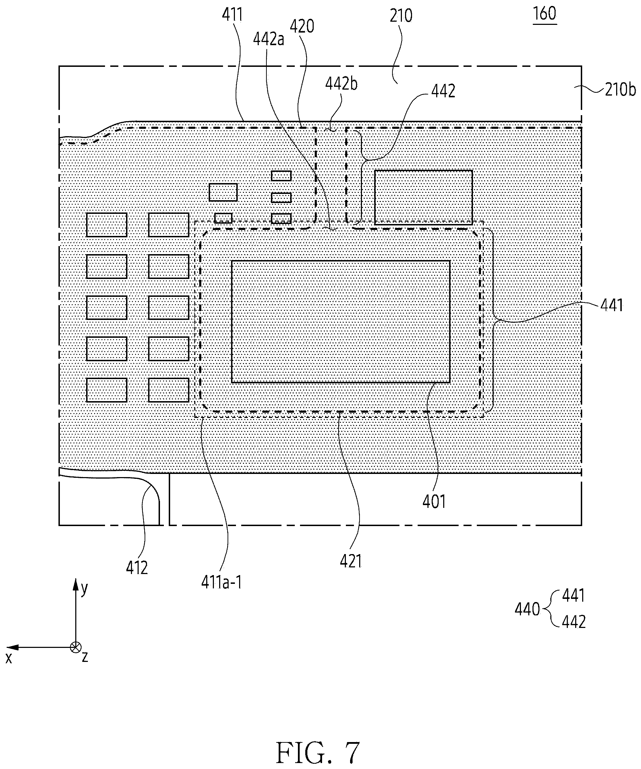

FIG. 7 is a top plan view of an exemplary display module according to an embodiment.

Referring to FIG. 7, according to an embodiment, an opening 421 may overlap a portion of a rigid region 411 in which an electronic component 401 is disposed when the rigid region 411 is viewed along a direction (e.g., a +z direction) in which a first surface 411a (e.g., the first surface 411a of FIG. 5B) faces.

According to an embodiment, an air gap 440 may include a first region 441 and a second region 442. The first region 441 may be disposed under the electronic component 401. The first region 441 may overlap the electronic component 401. The first region 441 may surround a periphery of the electronic component 401 when the rigid region 411 is viewed along the direction (e.g., the +z direction) in which the first surface faces. According to an embodiment, a magnitude of the first region 441 may be greater than or equal to a magnitude of the electronic component 401. An area of the first region 441 may be greater than or equal to an area of the electronic component 401. However, it is not limited thereto. For example, the magnitude of the first region 441 may be smaller than the magnitude of the electronic component 401.

According to an embodiment, when an adhesive member 420 is attached to a display 210, the second region 442 may provide a passage through which air between the display 210 and a portion of the adhesive member 420 excluding the air gap 440 may move to the outside of the adhesive member 420. When the adhesive member 420 is attached to the display 210, the second region 442 may guide movement of air between a portion of the adhesive member 420 excluding the air gap 440 and the display 210 toward the outside of the adhesive member 420. The second region 442 may connect the first region 441 to the outside of the adhesive member 420. The second region 442 may extend from the first region 441 toward the outside of the adhesive member 420. The second region 442 may extend from the first region 441 toward the outside of the adhesive member 420 along a direction (e.g., a +x direction, a -x direction, a +y direction, or a -y direction) parallel to another surface 210b of the display 210. An end 442a of the second region 442 may be connected to the first region 441. Another end 442b of the second region 442 opposite to the end 442a of the second region 442 may be connected to the outside of the adhesive member 420. According to an embodiment, a flexible region 412 may be close to the end 442a of the end 442a and the other end 442b of the second region 442. For example, a distance between the flexible region 412 and the end 442a of the second region 442 may be greater than a distance between the flexible region 412 and the other end 442b of the second region 442. According to an embodiment, the second region 442 may extend from the first region 441 along a second direction (e.g., the +y direction) opposite to a first direction (e.g., the -y direction) in which a first side surface (e.g., the first side surface 210c-1 of FIGS. 5A and 5B) of the display 210 faces. However, it is not limited thereto. For example, the second region 442 may extend along a direction different from the second direction (e.g., the +y direction). For example, the second region 442 may extend along the first direction (e.g., the -y direction). In case that the second region 442 extends along the first direction (e.g., the -y direction), the flexible region 412 may be close to the other end 442b of the second region 442 among the end 442a and the other end 442b of the second region 442. For example, the second region 442 may extend along a third direction (e.g., the +x direction) perpendicular to the first direction (e.g., the -y direction). For example, the second region 442 may extend along a fourth direction (e.g., the -x direction) opposite to the third direction (e.g., the +x direction).

According to an embodiment, a magnitude of the second region 442 may be smaller than a magnitude of the first region 441. For example, a width of the second region 442 may be smaller than a width of the first region 441. A width of a component may mean a distance in a +x-axis direction or a -x-axis direction. However, it is not limited thereto. For example, the width of the second region 442 may be substantially the same as or greater than the width of the first region 441.

As described above, according to an embodiment, a display module 160 may provide a structure in which the adhesive member 420 may be stably attached to the display 210 by the second region 442 of the adhesive member 420.

The display module may include a display for providing visual content to a user and a printed circuit board electrically connected to the display. In order to meet requirement of a user, the printed circuit board in the display module may include another electronic component for controlling the electronic components included in the display. Since a portion of the display is exposed to the outside of an electronic device, the printed circuit board in the display module may be vulnerable to an impact transmitted from the outside of the electronic device. The display module and the electronic device may need a structure for decreasing damage to a component on the printed circuit board due to an impact transmitted from the outside of the electronic device.

According to an embodiment, an electronic device (e.g., the electronic device 300 of FIG. 6) may include a display (e.g., the display 210 of FIGS. 5A and 5B) including a touch sensor (e.g., the touch sensor 251 of FIG. 2) for detecting a user input from the outside of the electronic device. According to an embodiment, the electronic device may include a printed circuit board (e.g., the printed circuit board 410 of FIGS. 5A and 5B) including a rigid region (e.g., the rigid region 411 of FIGS. 5A and 5B) including a first surface (e.g., the first surface 411a of FIG. 5B) facing a surface (e.g., the other surface 210b of FIGS. 5A and 5B) of the display and a second surface (e.g., the second surface 411b of FIG. 5B) opposite to the first surface, and a flexible region (e.g., the flexible region 412 of FIG. 5A and FIG. 5B) connecting the rigid region and the display. According to an embodiment, the electronic device may include a touch sensor IC (e.g., the electronic component 401 of FIGS. 5A and 5B) disposed on the second surface and configured to control the touch sensor. According to an embodiment, the electronic device may include an adhesive member (e.g., the adhesive member 420 of FIG. 5B) in contact with the surface of the display and the first surface so that the rigid region may be attached to the surface of the display. According to an embodiment, the electronic device may include an air gap (e.g., the air gap 440 of FIG. 5B) interposed between a portion (e.g., the portion 411a-1 of FIG. 5B) of the first surface overlapping the touch sensor IC and the surface of the display and surrounded by the adhesive member.

According to an embodiment, the electronic device may provide a structure for decreasing damage to the touch sensor IC disposed on the rigid region by the air gap disposed between the rigid region and the display.

According to an embodiment, a magnitude of the air gap may be greater than or equal to a magnitude of the touch sensor IC when the rigid region is viewed along a direction in which the first surface faces.

According to an embodiment, the electronic device may provide a structure for decreasing damage to the touch sensor IC disposed on the rigid region by an air gap having a magnitude greater than or equal to a magnitude of the touch sensor IC.

According to an embodiment, the air gap may surround a periphery of the touch sensor IC when the rigid region is viewed along the direction in which the first surface faces.

According to an embodiment, since the periphery of the touch sensor IC is disposed on the air gap, the electronic device may provide a structure for decreasing damage to the touch sensor IC disposed on the rigid region.

According to an embodiment, the flexible region may extend from the rigid region to a side surface (e.g., the first side surface 210c-1 of FIG. 5B) of the display perpendicular to the surface of the display and may be bent with respect to the surface of the display.

According to an embodiment, since the flexible region may be bent, the electronic device may provide a structure in which a display may be disposed in various shapes of spaces in the electronic device.

According to an embodiment, the electronic device may include a support member (e.g., the support member 450 of FIG. 6) that supports the surface of the display and defines at least a portion of an outer surface of the electronic device.

According to an embodiment, the electronic device may include a support structure (e.g., the support structure 460 of FIG. 6) disposed in the support member and spaced apart from the display along a direction in which the surface of the display faces. According to an embodiment, the touch sensor IC may overlap at least a portion of the support structure.

According to an embodiment, the electronic device may provide a structure capable of buffering an impact due to a temporary contact between the touch sensor IC and the support structure by an air gap formed between a first surface of the rigid region and the display.

According to an embodiment, the air gap may include a first region (e.g., the first region 441 of FIG. 7) that overlaps the touch sensor IC. According to an embodiment, the air gap may include a second region (e.g., the second region 442 of FIG. 7) extending from the first region toward the outside of the adhesive member along a direction parallel to the surface of the display.

According to an embodiment, the electronic device may provide a structure capable of guiding air between the adhesive member and the display to the outside of the adhesive member while the adhesive member is attached to the display by the second region connected to the outside of the adhesive member.

According to an embodiment, the flexible region may be connected to a side surface (e.g., the first side surface 210c-1 of FIG. 5B) of the display facing the first direction. According to an embodiment, the second region may extend along a second direction opposite to the first direction.

According to an embodiment, the electronic device may provide a structure in which the adhesive member may be stably attached to a display since the second region is formed in the same direction as the attachment direction of the adhesive member.

According to an embodiment, a width of the second region may be smaller than a width of the first region.

According to an embodiment, the electronic device may include display driving circuitry (e.g., the display driving circuitry 230 of FIGS. 5A and 5B) disposed on the flexible region and configured to drive the display.

According to an embodiment, the electronic device may provide a structure capable of protecting a touch sensor IC that is more vulnerable to an impact than the display driving circuitry disposed on the flexible region by an air gap disposed between the rigid region and the display.

According to an embodiment, the electronic device may include a window (e.g., the window 430 of FIGS. 5A and 5B) disposed on another surface of the display opposite to the surface of the display.

According to an embodiment, the electronic device may provide a structure capable of protecting the display by the window disposed on the display.

According to an embodiment, the electronic device may include an adhesive layer interposed between the window and the other surface of the display.

According to an embodiment, the electronic device may provide a structure capable of protecting the display by an adhesive layer interposed between the window and the display.

According to an embodiment, the adhesive member may include an adhesive material disposed on a surface of the adhesive member facing the surface of the display.

According to an embodiment, the electronic device may provide a structure in which the adhesive member may be stably attached to the display by the adhesive material disposed on the surface facing the display.

According to an embodiment, the adhesive member may include an adhesive material disposed on a surface of the adhesive member facing the first surface.

According to an embodiment, the electronic device may provide a structure in which an adhesive member may be stably attached to the rigid region by an adhesive material disposed on a surface facing the rigid region.

According to an embodiment, the electronic device may include a sensor (e.g., the sensor 176a of FIGS. 5A and 5B) disposed on the surface of the display and spaced apart from the rigid region. According to an embodiment, the electronic device may include another printed circuit board (e.g., the other printed circuit board 176b of FIG. 5A) connecting the sensor and the rigid region.

According to an embodiment, a display module (e.g., the display module 160 of FIGS. 5A and 5B) may include a display (e.g., the display 210 of FIGS. 5A and 5B) including a touch sensor (e.g., the touch sensor 251 of FIG. 2) for detecting a user input from the outside. According to an embodiment, the display module may include a printed circuit board (e.g., the printed circuit board 410 of FIGS. 5A and 5B) including a rigid region (e.g., the rigid region 411 of FIGS. 5A and 5B) including a first surface (e.g., the first surface 411a of FIG. 5B) facing a surface (e.g., the other surface 210b of FIGS. 5A and 5B) of the display and a second surface (e.g., the second surface 411b of FIG. 5B) opposite to the first surface, and a flexible region (e.g., the flexible region 412 of FIG. 5A and FIG. 5B) connecting the rigid region and the display. According to an embodiment, the display module may include a touch sensor IC (e.g., the electronic component 401 of FIGS. 5A and 5B) disposed on the second surface and configured to control the touch sensor. According to an embodiment, the display module may include an adhesive member (e.g., the adhesive member 420 of FIG. 5B) in contact with the surface of the display and the first surface so that the rigid region may be attached to the surface of the display. According to an embodiment, the display module may include an air gap (e.g., the air gap 440 of FIG. 5B) interposed between a portion (e.g., the portion 411a-1 of FIG. 5B) of the first surface overlapping the touch sensor IC and the surface of the display and surrounded by the adhesive member.

According to an embodiment, a magnitude of the air gap may be greater than or equal to a magnitude of the touch sensor IC when the rigid region is viewed along a direction in which the first surface faces.

According to an embodiment, the electronic device may provide a structure for decreasing damage to the touch sensor IC disposed on the rigid region by an air gap having a magnitude greater than or equal to the magnitude of the touch sensor IC.

According to an embodiment, the flexible region may extend from the rigid region to a side surface (e.g., the first side surface 210c-1 of FIG. 5B) of the display perpendicular to the surface of the display and may be bent with respect to the surface of the display.

According to an embodiment, since the flexible region may be bent, the electronic device may provide a structure in which a display may be disposed in various shapes of spaces in the electronic device.

According to an embodiment, the air gap may include the first region (e.g., the first region 441 of FIG. 7) overlapping the touch sensor IC. According to an embodiment, the air gap may include a second region (e.g., the second region 442 of FIG. 7) extending from the first region toward the outside of the adhesive member along a direction parallel to the surface of the display.

According to an embodiment, the electronic device may provide a structure capable of guiding air between the adhesive member and the display to the outside of the adhesive member while the adhesive member is attached to the display by the second region connected to the outside of the adhesive member.

According to an embodiment, the electronic device may include display driving circuitry (e.g., the display driving circuitry 230 of FIGS. 5A and 5B) disposed on the flexible region and configured to drive the display.

According to an embodiment, the electronic device may provide a structure capable of protecting the touch sensor IC that is more vulnerable to an impact than the display driving circuitry disposed on a flexible region by an air gap disposed between the rigid region and the display.

An electronic device (e.g., the electronic device 300 of FIG. 6) is provided. According to an embodiment, the electronic device may comprise a display (e.g., the display 210 of FIGS. 5A and 5B). According to an embodiment, the electronic device may comprise a first printed circuit board (e.g., the flexible region 412 of FIGS. 5A and 5B) on which display driving circuitry (e.g., the display driving circuitry 230 of FIGS. 5A and 5B) is disposed, connected to the display. According to an embodiment, the electronic device may comprise a second printed circuit board (e.g., the rigid region 411 of FIGS. 5A and 5B) disposed on a surface of the display and connected to the first printed circuit board. According to an embodiment, the electronic device may comprise a support member (e.g., the adhesive member 420 of FIGS. 5A and 5B) disposed between the surface of the display and a first surface (e.g., the first surface 411a of FIGS. 5A and 5B) of the second printed circuit board, facing the surface of the display. According to an embodiment, the electronic device may comprise an electronic component (e.g., the electronic component 401 of FIGS. 5A and 5B) disposed on a second surface (e.g., the second surface 411b of FIG. 5B) of the second printed circuit board, opposite to the first surface. According to an embodiment, the support member may comprise an opening (e.g., the opening 421 of FIG. 5B) forming an air gap (e.g., the air gap 440 of FIG. 5B) disposed between a portion (e.g., the portion 411a-1 of FIG. 5B) of the first surface corresponding to the electronic component and the surface of the display.

According to an embodiment, the electronic component may comprise at least one of a touch sensor integrated circuit (IC), a fingerprint sensor IC, a pressure sensor IC, a proximity sensor IC, or a light sensor IC.

According to an embodiment, the support member may be adhered to at least one of the surface of the display and the first surface.

According to an embodiment, the surface of the display may be defined by at least one of a copper sheet or an insulating sheet, included in the display.

According to an embodiment, the second printed circuit board may comprise a supporting plate with stiffness, included in a portion of the second printed circuit board on which the electronic component is disposed.

According to an embodiment, the supporting plate may comprise at least one of a metal material, a plastic, or a carbon.

According to an embodiment, the opening may overlap a portion of the second printed circuit board on which the electronic component is disposed, when the second printed circuit board is viewed along a direction in which the first surface faces.

According to an embodiment, an air gap formed by the opening may comprise a first region (e.g., the first region 441 of FIG. 7) overlapped with the electronic component. According to an embodiment, the air gap formed by the opening may comprise a second region (e.g., the second region 442 of FIG. 7) extended from the first region toward an outside of the support member in a direction parallel to the surface of the display.

According to an embodiment, the second printed circuit board may be formed integrally with the first printed circuit board.

According to an embodiment, at least one of the first printed circuit board and the second printed circuit board may have flexibility.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101; 300) comprising:
a display (210);
a first printed circuit board (412) on which display driving circuitry (230) is disposed, connected to the display (210);
a second printed circuit board (411) disposed on a surface (210b) of the display (210) and connected to the first printed circuit board (412);
a support member (420) disposed between the surface (210b) of the display (210) and a first surface (411a) of the second printed circuit board (411), facing the surface (210b) of the display (210); and
an electronic component (401) disposed on a second surface (411b) of the second printed circuit board (411), opposite to the first surface (411a),
wherein the support member (420) comprises an opening (421) forming an air gap (440) disposed between a portion (411a-1) of the first surface (411a) corresponding to the electronic component (401) and the surface (210b) of the display (210).

2. The electronic device (101; 300) of claim 1, wherein the electronic component (401) comprises at least one of a touch sensor integrated circuit (IC), a fingerprint sensor IC, a pressure sensor IC, a proximity sensor IC, or a light sensor IC.

3. The electronic device (101; 300) of any one of claim 1 and claim 2, wherein the support member (420) is adhered to at least one of the surface (210b) of the display (210) and the first surface (411a).

4. The electronic device (101; 300) of any one of claims 1 to 3, wherein the surface (210b) of the display (210) is defined by at least one of a copper sheet or an insulating sheet, included in the display (210).

5. The electronic device (101; 300) of any one of claims 1 to 4, wherein the second printed circuit board (411) comprises a supporting plate with stiffness, included in a portion of the second printed circuit board (411) on which the electronic component (401) is disposed.

6. The electronic device (101; 300) of claim 5, wherein the supporting plate comprises at least one of a metal material, a plastic, or a carbon.

7. The electronic device (101; 300) of any one of claims 1 to 6, wherein the opening (421) overlaps a portion of the second printed circuit board (411) on which the electronic component (401) is disposed when the second printed circuit board (411) is viewed along a direction in which the first surface (411a) faces.

8. The electronic device (101; 300) of any one of claims 1 to 7, wherein the air gap (440) comprises:
a first region (441) overlapped with the electronic component (401); and
a second region (442) extended from the first region (441) toward an outside of the support member (420) in a direction parallel to the surface (210b) of the display (210).

9. The electronic device (101; 300) of claim 8, wherein the first printed circuit board is connected to a side surface of the display (210), facing a first direction, and
wherein the second region (442) is extended along a second direction opposite to the first direction.

10. The electronic device (101; 300) of claim 8, wherein a width of the second region (442) is smaller than a width of the first region (441).

11. The electronic device (101; 300) of any one of claims 1 to 10, wherein a thickness of the support member (401) is 0.01 mm to 0.1 mm.

12. The electronic device (101; 300) of any one of claims 1 to 11, wherein the second printed circuit board (411) is formed integrally with the first printed circuit board.

13. The electronic device (101; 300) of any one of claims 1 to 12, wherein at least one of the first printed circuit board and the second printed circuit board (411) has flexibility.

14. The electronic device (101; 300) of any one of claims 1 to 13, wherein the electronic device (101; 300) further comprises a window (430) disposed on another surface (210a) of the display (210) opposed to the surface (210b) of the display (210).

15. The electronic device (101; 300) of any one of claims 1 to 14, wherein the electronic device (101; 300) further comprises:
a sensor (176a) disposed outside of the second printed circuit board (411) and disposed on the surface (210b) of the display (210); and
another printed circuit board (176b) connecting the sensor (176a) and the second printed circuit board (411).
